# EUROPÄISCHE PATENTSCHRIFT

(11) **EP 2 483 848 B1**
(45) Veröffentlichungstag und Bekanntmachung des Hinweises auf die Patenterteilung: **03.07.2013**
(21) Anmeldenummer: 10759916.9
(22) Anmeldetag: 30.09.2010
(51) Int. Cl.: G06K 19/077

(54) **FUNKTIONELLES LAMINAT UND HERSTELLUNGSVERFAHREN**
FUNCTIONAL LAMINATE
STRATIFIÉ FONCTIONNEL

(30) Priorität: 30.09.2009 DE 102009043587
(43) Veröffentlichungstag der Anmeldung: 08.08.2012
(73) Patentinhaber: Smartrac IP B.V., 1077 XX Amsterdam (NL); Michalk, Manfred, 99092 Erfurt (DE)
(72) Erfinder: MICHALK, Manfred, 99092 Erfurt (DE)
(74) Vertreter: Böck, Bernhard
(86) Internationale Anmeldenummer: PCT/EP2010/064598
(87) Internationale Veröffentlichungsnummer: WO 2011/039327

(56) Entgegenhaltungen:
- WO-A1-2004/057528
- WO-A1-2007/061303
- DE-A1- 19 701 163
- US-A- 6 111 303
- US-A1- 2007 141 760

## Beschreibung

Die Erfindung betrifft ein funktionelles Laminat und ein Verfahren zu seiner Herstellung.

Funktionelle Laminate sind Dokumente, die durch Laminieren einer Vielzahl von Schichten gebildet werden. Sie werden insbesondere als Sicherheitsdokumente, wie zum Beispiel Smart Cards, ID Cards, Kreditkarten und Ähnliches, verwendet.

Als funktionelle Laminate werden auch halbfertige Produkte bezeichnet, so genannte Prelaminate oder Inlays, die beispielsweise zur Herstellung von Smart Cards verwendet werden, die mit funktionellen Komponenten wie beispielsweise Chips, Chipmodulen, RFID-Antennen, Schaltern und Ähnlichem versehen sind. Funktionelle Laminate umfassen gewöhnlich eine Anzahl von Schichten mit einem in mindestens eine der Schichten eingebetteten Chip oder Chipmodul. Die Schichten bestehen meist aus einem Plastikmaterial, wie beispielsweise Polycarbonat oder Polyethylenterephthalat.

Die Schichten werden mittels Wärmeeintrag und/oder Druck miteinander laminiert. Dabei neigen die Makromoleküle der Plastikmaterialien dazu, sich zu verkürzen, so dass das Plastikmaterial schrumpft, das heißt seine Flächenausdehnung verringert sich, während sich seine Dicke vergrößert. Der Chip oder das Chipmodul jedoch schrumpfen nicht, so dass sich mechanische Spannungen ergeben, die zu Verformungen, Rissen oder zur Delaminierung des Materials führen können. Ebenso können mechanische Spannungen zur Beschädigung der funktionellen Komponenten oder deren Kontaktierung mit Leitern, Drähten oder Antennenspulen führen oder das Plastikmaterial im Bereich um die funktionellen Komponenten zerstören. Diese Schäden oder Zerstörungen treten insbesondere durch Kälteeinwirkung, bei mechanischen Belastungen wie Biegen oder Verwinden und infolge Einwirkung von Chemikalien wie Reinigungsmittel oder Kraftstoffe auf. Die resultierenden Zerstörungen des Plastikmaterials sind insbesondere als Risse oder Verwerfungen sichtbar. Abgesehen von der optischen Beeinträchtigung ist die Standzeit von Produkten aus solchen funktionellen Laminaten reduziert.

Ein weiteres Problem ist der relative große Wärmeausdehnungskoeffizient des Plastikmaterials im Vergleich zum Chip oder Chipmodul. Dadurch wirkt das flächenmäßig große Chipmodul als starrer Körper, auf den der Kunststoff, der unterhalb seines Erweichungspunktes ebenfalls starr ist (hohe Festigkeit, geringe Dehnung), durch den Laminiervorgang aufgeschrumpft ist. Dabei entstehen in Längs- und Querrichtung des Laminats direkt an den Kanten des Chipmoduls und insbesondere an seinen Ecken, da sich dort mechanische Spannungen aus Längs- und Querrichtung überlagern, besonders hohe Spannungen, die die Festigkeit des Kunststoffs überschreiten können. Auch diese Spannungen äußern sich durch Rissbildung in der Nähe des Moduls. Des Weiteren wirken Druckspannungen auf die Modulanschlüsse, die vom schrumpfenden Kunststoff der inneren Laminatschicht oder -schichten (auch Kernfolie genannt) verursacht sind, so, dass das Chipmodul mechanischem Druck ausgesetzt ist. Zum Spannungsabbau neigen die unter Druckbelastung stehenden Anschlüsse dazu, das Chipmodul aus der Ebene der Kernfolie heraus zu schieben. Dadurch drückt nun das Chipmodul mit seinen zu den äußeren Laminatschichten (auch Deckfolien oder Coverfolien genannt) weisenden relativ scharfen und harten Kanten und Ecken gegen die Deckfolien und verursacht dort insbesondere oberhalb der Ecken des Chipmoduls wiederum mechanische Spannungen, die, wenn sie die Festigkeitsgrenze des Kunststoffes überschreiten, zu Rissen in den Deckfolien führen.

In der DE 197 10 656 A1 ist eine Chipkarte offenbart, die mindestens ein elektronisches Bauteil in ihrem Inneren umfasst. Die Chipkarte weist eine Basisfolie auf, die mit einer Kernfolie verbunden ist. Die Kernfolie umfasst einen ausgestanzten Bereich, in den das mindestens eine elektronische Bauteil eingefügt ist. Der zwischen dem elektronischen Bauteil und den Rändern des ausgestanzten Bereichs verbliebene Freiraum ist mit einem fluide verarbeitbaren, verfestigten Füllmittel ausgefüllt.

Die WO 2007/089140 A1 offenbart ein Identitätsdokument, das aus einem Träger und einem darin aufgenommenen Chip besteht. Der Träger kann durch Laminieren verschiedener Schichten hergestellt werden, wobei ein oder mehrere dieser Schichten mit einer Öffnung zur Aufnahme des Chips versehen sind. Das Laminieren findet bei einer relativ hohen Temperatur statt. Der Träger und der Chip weisen unterschiedliche Schrumpfeigenschaften beim Abkühlen auf, was zu Spannungen und infolgedessen Rissen führen kann. Es wird vorgeschlagen, eine Hilfsschicht zwischen die direkt an den Chip angrenzende Schicht und die folgende Schicht einzufügen. Die Hilfsschicht besteht aus einem gummiartigen Material mit einem thermischen Ausdehnungskoeffizienten, der größer ist als der der beiden nebeneinander liegenden Schichten. Dies führt zu einer Vorspannung im Träger während der auf das Laminieren folgenden Abkühlung, so dass die Rissbildung verhindert wird. Zusätzlich dient eine solche Hilfsschicht als Stoppschicht für jegliche Rissbildung, die in der ersten Schicht auftreten kann, die direkt an den Chip angrenzt. In dieser ersten Schicht auftretende Risse können sich dank der Hilfsschicht nicht ohne weiteres in die angrenzende zweite Schicht ausbreiten, da die Hilfsschicht infolge ihrer Eigenschaften die Spannungen gleichmäßig über die zweite Schicht verteilt.

In der US 2004/0182939 A1 ist eine dünne, elektronische Chipkarte mit einem integrierten Schaltkreis und einem galvanischen Element als Energiequelle offenbart, das mindestens eine mit Lithium beschichtete Elektrode aufweist. Das galvanische Element hat ein dünnes, flexibles Gehäuse, umfassend zwei Metallfolien, die direkt gegen die Elektroden drücken und miteinander mit einem Kleber oder einer Dichtungsschicht dicht verbunden sind. Das Element ist in einer Ausnehmung der Chipkarte angeordnet. Die Chipkarte und das Element werden auf beiden Seiten durch eine Plastikdeckschicht bedeckt, die mittels eines elastischen, spannungskompensierenden Klebers, der sowohl an Metallen als auch an Plastik haftet, fest mit der Chipkarte und dem Element verbunden ist.

In der EP 0 880 754 B1 sind ein Verfahren und ein Gerät zum Bonden eines Drahtleiters zur Herstellung einer Transpondereinheit offenbart, die eine aus Draht gebildete Spule und eine Chip-Einheit umfasst und auf einem Substrat angeordnet ist. Während einer ersten Phase erstreckt sich der Drahtleiter über den Bondanschluss oder einen den Bondanschluss aufnehmenden Bereich. Der Drahtleiter ist bezüglich des Bondanschlusses oder aufnehmenden Bereiches am Substrat fixiert. Während einer zweiten Phase wird der Drahtleiter mittels Verbindungsmitteln mit dem Bondanschluss verbunden.

In der DE 44 35 802 A1 sind ein Verfahren zur Herstellung von Datenträgern mit eingebetteten Elementen und eine Vorrichtung zur Durchführung des Verfahrens offenbart. Der Kartenkörper eines Datenträgers mit darin angeordneten Elementen wird in einer Pressvorrichtung aus einer verpressten Formmasse hergestellt. Diejenigen Elemente, die in den Kartenkörper eingebettet werden sollen, werden bereits vor dem Pressvorgang in die Pressvorrichtung eingebracht und dort positioniert und fixiert.

In der DE 196 01 202 A1 sind eine Datenträgerkarte und ein Verfahren zu deren Herstellung offenbart. Die Datenträgerkarte besteht aus drei Grundbausteinen. Der Kartenkörper ist in MID-Technik hergestellt und mit allen Funktionen des Gehäuses und der Elektrik ausgestattet. Das verwendete Halbleiterbauelement ist ein SMD-Bauelement in TSOP-Ausführung.

In der DE 102 34 751 B4 sind ein Verfahren zur Herstellung einer spritzgegossenen Chipkarte und eine nach dem Verfahren hergestellte Chipkarte offenbart. Im Verfahren zur Herstellung einer spritzgegossenen Chipkarte, welche einen Chipkartenkörper und eine in den Chipkartenkörper eingebettete Antennenspule zur kontaktlosen Datenübertragung aufweist, die aus mindestens einer Leiterbahn und damit verbundenen Kontaktflächen besteht, wird die Antennenspule einseitig auf die Flachseite einer Trägerfolie aufgebracht. Das Trägerfolienelement wird in die Kavität einer Spritzgusswerkzeugform, welche die Größe der Chipkarte aufweist, so eingelegt, dass sich die darauf aufgebrachte Antennenspule an der zum Inneren der Kavität weisenden Seite befindet. Die Kavität wird anschließend mit einem verflüssigten Kunststoffmaterial gefüllt. Nach Beendigung des Spritzgussvorganges wird in den Chipkartenkörper eine Ausnehmung für ein Chipmodul eingebracht. Die im Inneren des Chipkartenkörpers benachbart der Ausnehmung befindlichen Kontaktflächen der Antennenspule werden freigelegt. In die Ausnehmung wird ein Chipmodul eingesetzt. Die freigelegten Kontaktflächen werden mit korrespondierenden Abschlussflächen an dem Chipmodul elektrisch verbunden. Nach dem Aufbringen der Antennenspule auf das Trägerfolienelement wird dieses benachbart der Kontaktflächen partiell mittels Schlitzen so durchtrennt, dass in dem Trägerfolienelement einzelne Laschen mit darauf angeordneten Kontaktflächen gebildet werden. Unmittelbar nach dem Spritzgussvorgang werden die in dem Trägerfolienelement gebildeten Laschen in das noch nicht gehärtete Kunststoffmaterial eingedrückt.

In der DE 195 00 925 C2 ist ein Verfahren zur Herstellung einer kontaktlosen Chipkarte offenbart. Die Chipkarte umfasst ein Übertragungsmodul, welches in einem Kartenkörper eingebaut ist. Das Übertragungsmodul weist eine großflächige Antenne in Form einer Spule zur induktiven Daten- und Energieübertragung und/oder in Form elektrisch leitender Schichten zur kapazitiven Daten- und Energieübertragung auf. Des Weiteren weist das Übertragungsmodul Anschlussflächen zur elektrischen Ankopplung an das Chipmodul auf. Das Übertragungsmodul wird zwischen laminierten Schichten, welche den Kartenkörper bilden, oder in einem um das Übertragungsmodul einstückig gespritzten Kartenkörper eingebettet. Des Weiteren umfasst die Chipkarte ein in dem Kartenkörper eingebautes Chipmodul mit mindestens einem IC-Baustein. Das Chipmodul weist Anschlussflächen auf, über die es mit den Anschlussflächen des Übertragungsmoduls elektrisch verbunden wird. Es wird ein Zwischenerzeugnis bestehend aus dem im Kartenkörper eingebetteten Übertragungsmodul hergestellt. Dabei wird bei dem Zwischenerzeugnis eine zur Kartenvorderseite oder Kartenrückseite hin offene Kavität zur Aufnahme des Chipmoduls derart geschaffen, dass die Anschlussflächen des Übertragungsmoduls zumindest teilweise im Bereich der Kavität liegen. Erst danach wird in einem weiteren, separaten Verfahrensschritt das Chipmodul in die Kavität des Zwischenerzeugnisses zur Ausbildung einer funktionsfähigen, kontaktlosen Chipkarte eingebaut. In diesem Verfahrensschritt werden die Anschlussflächen des Chipmoduls mit den Anschlussflächen des Übertragungsmoduls elektrisch leitend verbunden.

In der DE 199 42 932 A1 ist ein Verfahren zum Herstellen von Chipkarten offenbart. Es wird zunächst ein Bogen mit mindestens der doppelten Fläche einer Chipkarte hergestellt. In diesen Bogen wird mindestens eine Falzlinie eingebracht, so dass auf jeder Seite symmetrisch zur Falzlinie mindestens die Fläche einer Chipkarte verbleibt. Weiterhin wird mindestens ein Bauelement und/oder eine Aussparung für ein Bauelement in bzw. auf den Bogen eingebracht bzw. aufgebracht und der Bogen auf einer Seite vollflächig oder bereichsweise mit einem aktivierbaren Kleber versehen. Anschließend wird der Bogen entlang der Falzlinie mit der Kleberfläche nach innen zusammengefaltet, gepresst und gleichzeitig der Kleber mit einem Verfahren aktiviert, welches das Material des Bogens im wesentlichen unverändert lässt, nämlich beispielsweise mittels Mikrowellen oder elektrisch durch Widerstandsschweißen oder im Magnetfeld oder durch den Pressdruck.

Die DE 197 01 163 A1 beschreibt eine elektrische Schaltung insbesondere für eine Chipkarte, wobei eine Kontaktlayoutschicht über einer Trägerschicht angeordnet wird, die eine Aufnahmeöffnung zur Aufnahme eines elektrischen Bauteils aufweist. Die Kontaktlayoutschicht weist dabei voneinander isolierte, elektrisch leitfähige Bereiche auf. Zudem ist vorgesehen, dass das elektrische Bauteil einen elektrischen Kontakt im Bereich einer Begrenzungswand der Aufnahmeöffnung aufweist, und dass sich die Kontaktlayoutschicht wenigstens teilweise in die Aufnahmeöffnung hineinerstreckt. Weiter sieht die Lehre der Druckschrift vor, dass in einem Bereich zwischen der Kontaktlayoutschicht und einer Begrenzungswand und/oder einem Bereich zwischen einer Kontaktlayoutschicht und einem elektrischen Bauteil wenigstens ein Hilfsstoff vorgesehen ist, der elektrisch leitfähig sein kann oder Füllstoffeigenschaften und/oder Hafteigenschaften aufweist.

Die WO 2007/061303 A1 offenbart zudem ein Ausweisdokument umfassend einen Chip, bei dessen Herstellung ein Puffermaterial zum Einsatz kommt, dass Spannungen im Ausweisdokument auf Grund der unterschiedlichen Ausdehnungs- und Schrumpfverhalten der bei der Herstellung des Ausweisdokuments eingesetzten Materialien vorbeugen soll. Die unabhängigen Ansprüche sind gegen diesen Stand der Technik abgegrenzt.

Der Erfindung liegt die Aufgabe zugrunde, ein verbessertes funktionelles Laminat und ein Verfahren zu dessen Herstellung anzugeben, bei dem die Gefahr der Bildung von Spannungsrissen verringert ist.

Die Aufgabe wird erfindungsgemäß gelöst durch ein Verfahren mit den Merkmalen des Anspruchs 1 und ein funktionelles Laminat mit den Merkmalen des Anspruchs 9.

Vorteilhafte Ausgestaltungen der Erfindung sind Gegenstand der Unteransprüche.

Ein erfindungsgemäßes Verfahren zur Herstellung eines funktionellen Laminats umfasst unter anderem folgende Schritte:
- Bereitstellen mindestens einer thermoplastischen Kunststofffolie als Substratschicht,
- Erzeugen mindestens eines Durchbruchs in der Substratschicht,
- Einbringen mindestens einer funktionellen Komponente in den Durchbruch,
- Laminieren der Substratschicht mit mindestens einer weiteren Kunststofffolie als Deckschicht unter Druck und Zuführung von Wärme.

Funktionelle Laminate sind Dokumente, die durch Laminieren einer Vielzahl von Schichten gebildet werden. Sie werden insbesondere als Sicherheitsdokumente, wie zum Beispiel Smart Cards, ID Cards, Kreditkarten und Ähnliches, verwendet. Als funktionelle Laminate werden auch halbfertige Produkte bezeichnet, so genannte Prelaminate oder Inlays, die beispielsweise zur Herstellung von Smart Cards verwendet werden, die mit funktionellen Komponenten wie beispielsweise Chips, Chipmodulen, RFID-Antennen, Schaltern und Ähnlichem versehen sind. Die Substratschicht des funktionellen Laminats kann aus einer Kunststofffolie oder aus mehreren Schichten von Kunststofffolien gebildet werden.

Es wird zudem ein weiches, elastisches und temperaturbeständiges Einbettungsmaterial so angeordnet, dass die funktionelle Komponente zumindest in der Substratschicht vom Einbettungsmaterial umgeben ist, das einen Wärmeausdehnungskoeffizienten aufweist, der mindestens so groß wie ein Wärmeausdehnungskoeffizient des Materials der Substratschicht und vorzugsweise auch der Deckschicht ist, wobei das Einbettungsmaterial und das Material der Substratschicht ein ähnliches oder gleiches Schrumpfverhalten bei Erwärmung aufweisen. Ein Schrumpfwert des Einbettungsmaterials ist insbesondere gleich groß oder größer als ein Schrumpfwert des Materials der Substratschicht und vorzugsweise auch des Materials der Deckschicht. Der Schrumpfwert bezeichnet eine Verkürzung einer bestimmten Folie in Länge und Breite, die durch Behandlung bei einer bestimmten Temperatur über eine bestimmte Zeitdauer auftritt. Schrumpfwerte sind aus Tabellen entnehmbar.

Das Einbettungsmaterial dient als Puffermaterial und verringert mechanische Spannungen in der Substratschicht und den Deckschichten durch Abbau von Spannungsspitzen. Das Einbettungsmaterial verteilt die durch das Schrumpfen beim Abkühlen nach dem Laminieren entstehenden Druckspannungen nahezu gleichmäßig im Durchbruch und verhindert dabei, dass der anderenfalls auftretende seitliche Druck auf die funktionelle Komponente (insbesondere ein Chipmodul und dessen Anschlüsse) die funktionelle Komponente aus der Ebene der Substratschicht herausdrückt.

Die funktionelle Komponente wird in das Einbettungsmaterial eingedrückt oder eingegossen, so dass die funktionelle Komponente in ihrer Flächenausdehnung vollständig im Einbettungsmaterial eingebettet ist. Eine Dicke des Einbettungsmaterials ist dabei gleich oder nahezu gleich einer Dicke der funktionellen Komponente nach dem Laminieren.

Insbesondere ist die funktionelle Komponente nur in der Substratschicht, jedoch nicht oder nicht wesentlich in Richtung der Deckschichten vom Einbettungsmaterial umgeben.

Auf diese Weise wird die Gefahr von Spannungsrissen in der Umgebung der funktionellen Komponente, beispielsweise eines integrierten Schaltkreises (Chip) oder eines Chipmoduls, infolge Wärmeeintrag beim Laminieren und Schrumpfen beim Abkühlen verringert, insbesondere in kritischen Bereichen wie Kanten und Ecken der funktionellen Komponente. Durch die Vermeidung von Spannungsrissen wird auch die Oberflächenqualität des Laminates verbessert.

Erfindungsgemäß ist das Einbettungsmaterial als ein Formstück mit einem Formstückdurchbruch gebildet, wobei die funktionelle Komponente zumindest teilweise in den Formstückdurchbruch eingebracht wird, wobei das Formstück vor oder nach dem Einbringen der funktionellen Komponente in den Durchbruch des Substrats eingebracht wird. Eine Vormontage der funktionalen Komponente mit dem Formstück ist mit hoher Produktivität möglich, die dabei entstehende Einheit ist besonders gut handhabbar. Die Montage dieser Einheit mit der Substratschicht kann mit herkömmlichen Produktionseinrichtungen erfolgen, wobei auf eine mehrfache Bearbeitung der Substratschicht verzichtet werden kann. Durch den Einsatz des Formstücks können lange Laminierzeiten oberhalb einer Erweichungstemperatur der Materialien vermieden werden. Mit der beschriebenen Vorgehensweise sind besonders dünne funktionelle Laminate mit besserer Oberflächenqualität, insbesondere nach dem Endlaminieren, erzielbar.

Gemäß einer weiteren Ausführungsform der Erfindung wird ein Leiterband oder Leiterdraht in oder auf der Substratschicht zu einem Schaltungsmuster, beispielsweise einer Antennenspule, verlegt. Kontaktierungsstellen des Leiterbandes oder Leiterdrahtes werden mit den Anschlüssen der funktionellen Komponente kontaktiert. Das Laminieren der Substratschicht mit mindestens einer weiteren Kunststofffolie als Deckschicht unter Druck und Zuführung von Wärme erfolgt vorzugsweise nach dem Kontaktieren der Kontaktierungsstellen mit den Anschlüssen, insbesondere natürlich auf der Substratseite, auf welcher die Kontaktierungsstellen und Anschlüsse angeordnet sind. Querungsbereiche der Leiterbahn oder des Leiterdrahts, die die Kontaktierungsstellen umfassen, werden vor Montage der funktionellen Komponente auf einer Verlegeseite über den Durchbruch geführt und mittels eines Stempels oder mittels der funktionellen Komponente in den Durchbruch oder durch den Durchbruch gebogen. Die Leiterbahn oder der Leiterdraht werden auf beiden Seiten des Durchbruchs am Substrat befestigt, beispielsweise angeheftet. Auch in dieser Ausführungsform kann vorgesehen sein, dass ein weiches, elastisches und temperaturbeständiges Einbettungsmaterial so angeordnet wird, dass die funktionelle Komponente zumindest in der Substratschicht vom Einbettungsmaterial umgeben ist, das einen Wärmeausdehnungskoeffizienten aufweist, der mindestens so groß wie ein Wärmeausdehnungskoeffizient des Materials der Substratschicht ist, wobei das Einbettungsmaterial und das Material der Substratschicht ein ähnliches oder gleiches Schrumpfverhalten bei Erwärmung aufweisen. Ein Schrumpfwert des Einbettungsmaterials ist insbesondere gleich groß oder größer als ein Schrumpfwert des Materials der Substratschicht und vorzugsweise auch des Materials der Deckschicht. Der Schrumpfwert bezeichnet eine Verkürzung einer bestimmten Folie in Länge und Breite, die durch Behandlung bei einer bestimmten Temperatur über eine bestimmte Zeitdauer auftritt. Schrumpfwerte sind aus Tabellen entnehmbar.

Das Formstück kann beispielsweise auch aus mehreren Formstückteilen gleichen oder unterschiedlichen Materials gebildet werden. Die funktionelle Komponente kann von mehreren miteinander verbundenen oder nicht miteinander verbundenen Formstückteilen zumindest teilweise umgeben werden, wobei dies vor oder nach dem Einbringen der funktionellen Komponente in den Durchbruch erfolgen kann.

Insbesondere ist eine Fläche des Formstücks mit der eingesetzten funktionellen Komponente in der Draufsicht kleiner als eine Fläche des Durchbruchs, wobei eine Dicke des Formstücks größer sein kann als eine Gesamtdicke der funktionellen Komponente und wobei eine Dicke der Substratschicht fast so groß ist wie die Dicke des Formstücks. Hierdurch kann das Formstück besonders einfach in den Durchbruch der Substratschicht eingesetzt werden.

Auch in der ersten erfindungsgemäßen Ausführungsform kann als funktionelle Komponente ein Chipmodul oder ein Chip mit mindestens zwei Anschlüssen verwendet werden, wobei ein Leiterband oder Leiterdraht in oder auf der Substratschicht zu einem Schaltungsmuster verlegt wird und wobei Kontaktierungsstellen des Leiterbandes oder Leiterdrahtes mit den Anschlüssen kontaktiert werden. Ein Chipmodul besteht aus einem dünnen, flächigen, metallischen Träger, auf dessen mittlerem Bereich ein Halbleiter-Chip montiert ist. Der Chip ist mittels eines aufgespritzten Modulkörpers aus Duroplast oder Thermoplast geschützt.

Die funktionelle Komponente kann in das Formstück eingedrückt oder eingegossen werden. Dabei bedeutet eingegossen, dass die funktionelle Komponente mit dem Material des Formstücks zumindest teilweise umgossen wird.

Die Kontaktierungsstellen des Leiterbandes oder Leiterdrahtes können mit den Anschlüssen vor oder nach der Montage der funktionellen Komponente mit dem Formstück kontaktiert werden. Dabei können die Kontaktierungsstellen vor dem Kontaktieren bereits entisoliert sein. Insbesondere beim Kontaktieren durch Schweißen können die Kontaktierungsstellen jedoch vor dem Kontaktieren auch noch isoliert sein, da die Isolierung während des Kontaktiervorgangs durch das Schweißen entfernt wird.

Vorzugsweise werden zum Kontaktieren die Kontaktierungsstellen des Leiterbandes oder Leiterdrahtes und/oder die Anschlüsse mit einer Lotpaste versehen, deren Schmelztemperatur unterhalb einer für das Laminieren verwendeten Temperatur liegt, wobei die Kontaktierungsstellen des Leiterbandes oder Leiterdrahtes mit den Anschlüssen während des Laminierens kontaktiert werden. Vorteilhaft ist dabei, dass kein zusätzlicher Schweißprozess erforderlich ist.

Mindestens eine der Deckschichten kann vor der Montage der funktionellen Komponente an eine Seite der Substratschicht angeheftet werden.

Das funktionelle Laminat kann nach dem Laminieren innerhalb einer Laminierpresse bei anhaltendem oder erhöhtem Druck unter eine Erweichungstemperatur des Materials der Substratschicht abgekühlt werden. Auf diese Weise kann der Schrumpf der Schichten weiter verringert werden.

Das Formstück kann durch Gießen oder durch heißes Prägen oder durch einen Schneidvorgang oder durch Eingießen der funktionellen Komponente hergestellt werden.

Vorzugsweise wird als Einbettungsmaterial ein bis mindestens 200°C temperaturbeständiges, thermoplastisches Polyurethan verwendet.

Der Formstückdurchbruch ist vorzugsweise kleiner als der darin einzubringende Teil der funktionellen Komponente, wobei die funktionelle Komponente in den Formstückdurchbruch eingedrückt wird.

Die funktionelle Komponente und/oder das Formstück werden/wird bevorzugt vor dem Eindrücken erwärmt.

Als Material der Substratschicht und/oder der Deckschicht wird bevorzugt Polycarbonat verwendet.

Das vormontierte Formstück mit der funktionellen Komponente kann in den Durchbruch eingesetzt und an der Deckschicht angeheftet werden.

Die Kontaktierungsstellen der Leiterbahn oder des Leiterdrahtes werden mit den Anschlüssen vorzugsweise durch Schweißen oder Löten oder impulsartige Thermokompression verbunden.

Die Querungsbereiche der Leiterbahn oder des Leiterdrahts können auf einer Verlegeseite über den Durchbruch geführt und mittels eines Stempels durch den Durchbruch auf eine der Verlegeseite gegenüberliegende Seite der Substratschicht gebogen werden. Anschließend werden das Chipmodul oder der Chip mit den Anschlüssen voran in den Durchbruch eingebracht.

Das Einformen, Biegen oder Niederdrücken der Querungsbereiche des Leiterbandes oder Leiterdrahtes ist vorteilhaft, weil auf dem Montageautomaten die weiteren Bestückungsvorgänge von der Verlegeseite des Schaltungsmusters erfolgen können und kein Wenden der Schichten erforderlich ist. Dies ist insbesondere günstig bei kontinuierlich arbeitender, so genannter Reel-to-Reel-Bearbeitung oder bei sonstiger Automatenbearbeitung der Folien. Das Einformen der Leiterbänder oder Leiterdrähte ist auch dann vorteilhaft, wenn statt Chipmodulen "nackte" Chips verarbeitet werden, wegen deren geringerer Abmessungen geringere mechanische Spannungen auftreten, so dass nicht zwingend Einbettungsmaterial benötigt wird. Die weichen und mit Isolierlack beschichteten Leiterbänder oder Leiterdrähte vermindern bei richtiger Platzierung die Spannungsspitzen im Material der Substratschicht entlang einiger scharfer Kanten des Chips oder Chipmoduls.

Bei Verwendung von Leiterdraht mit rundem Querschnitt können dessen Kontaktierungsstellen mittels eines Stempels gegen einen Amboss gedrückt und dadurch planiert werden, so dass sich eine breite Kontaktfläche ergibt.

Gewöhnlich ist die Verwendung von isoliertem Leiterdraht oder isolierter Leiterbahn erforderlich. Dabei können die Kontaktierungsstellen der Leiterbahn oder des Leiterdrahtes vor dem Kontaktieren abisoliert werden, insbesondere wenn der Leiter gelötet werden soll. Dies kann mittels eines CO₂-Lasers erfolgen. Wird der Leiter durch Schweißen kontaktiert, ist ein vorheriges Abisolieren nicht unbedingt erforderlich.

In einer bevorzugten Ausführungsform wird das Formstück auf einer der Deckschichten angeheftet. Die funktionelle Komponente wird auf einer anderen der Deckschichten angeheftet. Das Schaltungsmuster wird auf der Substratschicht mit über den Durchbruch geführten Querungsbereichen der Leiterbahn oder des Leiterdrahtes verlegt. Die Substratschicht und die Deckschicht mit der funktionellen Komponente werden so zusammengeheftet, dass die Anschlüsse der funktionellen Komponente die Querungsbereiche der Leiterbahn oder des Leiterdrahtes durch den Durchbruch biegt, so dass die Kontaktierungsstellen von der Verlegeseite aus gesehen unter den Anschlüssen liegen, woraufhin die Kontaktierung durchgeführt wird. Schließlich wird die Deckschicht mit dem Formstück an das Substrat angeheftet und anschließend laminiert.

Der Vorteil dieser Anordnung ist, dass der Leiterdraht oder das Leiterband unter dem Anschluss des Chipmoduls in Richtung Substratschichtmitte liegt und so jegliche Kerbwirkung des Leiterbandes oder Leiterdrahtes, welches sonst oberhalb der Anschlüsse in die sehr dünne Deckschicht drückt, ausgeschlossen ist.

Das Anheften der Deckschichten an der Substratschicht, der funktionellen Komponente an der Deckschicht oder des Formstücks an der Deckschicht kann thermisch oder mittels eines Klebers erfolgen.

Insbesondere wird die funktionale Komponente mittels einer Haftkleberfläche an die Deckschicht geheftet, wobei die Haftkleberfläche größer ist als eine Fläche der funktionalen Komponente. Die Haftkleberschicht wirkt zusätzlich der Bildung von Spannungen und somit der Rissbildung entgegen.

Ein Material der Deckschicht und das Material der Substratschicht weisen vorzugsweise den gleichen Wärmeausdehnungskoeffizienten und ein ähnliches oder gleiches Schrumpfverhalten bei Erwärmung auf. Insbesondere bestehen die Substratschicht und die Deckschicht aus dem gleichen Material.

Es können mehrere funktionelle Laminate als Teil eines Mehrfachnutzens in Bogen - oder Rollenform gleichzeitig oder nacheinander hergestellt werden.

Die Dicke des Formstücks ist etwas größer als die summierte Dicke der Anschlüsse und des Modulkörpers, da dann das Formstück einfach in den wiederum etwas flächenmäßig größeren Durchbruch der Substratschicht eingesetzt werden kann.

Ausführungsbeispiele der Erfindung werden im Folgenden anhand von Zeichnungen näher erläutert.

Darin zeigen:
- Figur 1: eine Querschnittsansicht eines Chipmoduls, umfassend einen Modulkörper und zwei Anschlüsse zur Kontaktierung,
- Figur 2: eine Querschnittsansicht eines Formstücks zur Aufnahme des Chipmoduls aus Figur 1 in einem Formstückdurchbruch,
- Figur 3: eine Querschnittsansicht einer weiteren Ausführungsform eines Formstücks zur Aufnahme des Chipmoduls aus Figur 1 in einem Formstückdurchbruch,
- Figur 4: ein durch einen Schneidvorgang hergestelltes Formstück nach dem Eindrücken des Modulkörpers in den Formstückdurchbruch,
- Figur 5: das Formstück aus Figur 4 in der Draufsicht,
- Figur 6: eine Substratschicht mit einem Durchbruch zur Aufnahme des Formstückes und eine Deckschicht,
- Figur 7: eine Querschnittsansicht durch ein funktionelles Laminat in Form eines Vorlaminats,
- Figur 8: eine Substratschicht mit untergehefteter Deckschicht nach dem Verlegen eines Leiterbandes auf einer Oberseite der Substratschicht über den Durchbruch hinweg,
- Figur 9: die Substratschicht und die Deckschicht aus Figur 8, wobei Kontaktierungsstellen des Leiterbandes auf die untere Deckschicht gedrückt sind,
- Figur 10: die Substratschicht und die Deckschicht aus Figur 9 nach dem Einsetzen des vormontierten Formstückes,
- Figur 11: eine Deckschicht mit angeheftetem Formstück und eine weitere Deckschicht mit angeheftetem Chipmodul,
- Figur 12: eine Querschnittsansicht eines Ausschnitts der Substratschicht,
- Figur 13: die mit der Substratschicht aus Figur 12 zusammengeheftete Deckschicht mit den aufgehefteten Chipmodulen aus Figur 11,
- Figur 14: die Substratschicht und die Deckschicht aus Figur 13 bei der Montage mit der Deckschicht mit den angehefteten Formstücken aus Figur 11, und
- Figur 15: ein sich aus der Montage in Figur 14 ergebendes funktionelles Laminat.

Einander entsprechende Teile sind in allen Figuren mit den gleichen Bezugszeichen versehen.

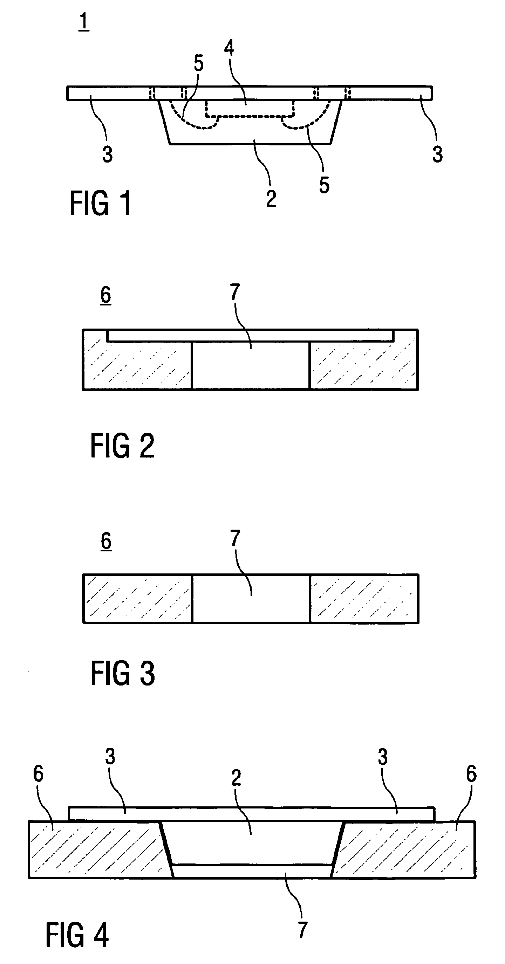

Figur 1 zeigt eine Querschnittsansicht eines Chipmoduls 1, umfassend einen Modulkörper 2 und zwei Anschlüsse 3 zur Kontaktierung mit einer Antennenspule (nicht gezeigt). Der Modulkörper beinhaltet einen integrierten elektronischen Schaltkreis 4 (Chip), der intern mittels Kontaktierdrähten 5 zu den Anschlüssen 3 kontaktiert ist.

Das Chipmodul 1 kann beispielsweise folgende Abmessungen aufweisen:
Länge der Anschlüsse 3: 2,5 mm;
Dicke der Anschlüsse 3: 0,08 mm;
Länge des Modulkörpers 2: 5 mm;
Dicke des Modulkörpers 2: 0.22 mm;
Breite des Modulkörpers 2 und der Anschlüsse 3: 5 mm.

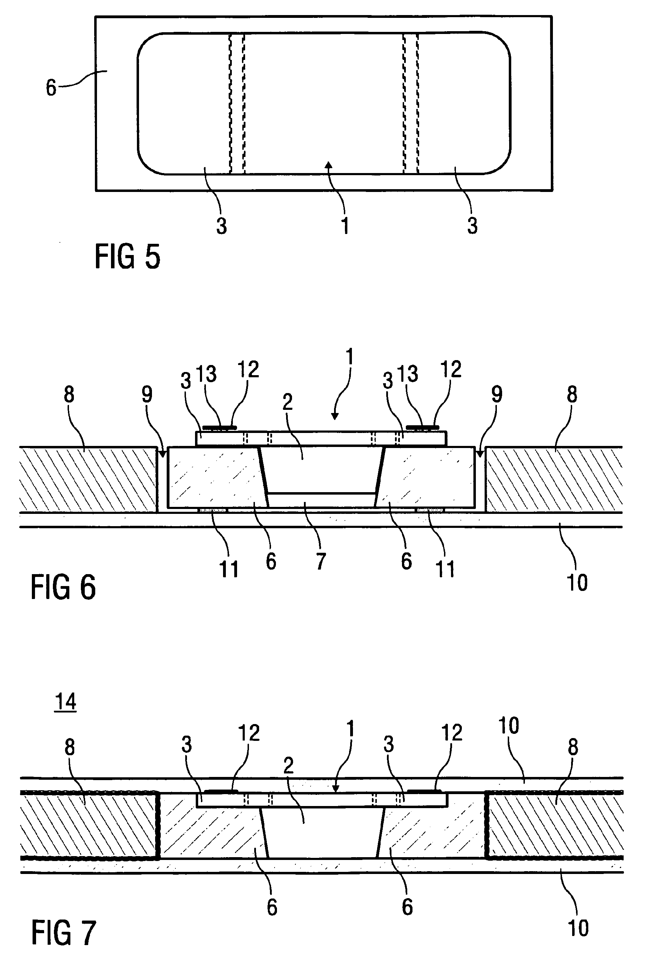

Die Figuren 2 und 3 zeigen Querschnittsansichten von Formstücken 6 zur Aufnahme des Chipmoduls 1 aus Figur 1 in einem Formstückdurchbruch 7. Das Formstück 6 kann beispielsweise durch Gießen, Stanzen oder durch einen Schneidvorgang hergestellt werden. Ebenso können Formstücke 6 durch heißes Prägen oder durch Eingießen des Chipmoduls 1 hergestellt werden. Beispielsweise weist das Formstück 6 eine Länge von 13 mm, eine Breite von 8 mm und eine Dicke von 0,35 mm auf. Die Dicke des Formstücks 6 ist etwas größer als die summierte Dicke der Anschlüsse 3 und des Modulkörpers 2. Das Formstück 6 wird in einen Durchbruch in der Substratschicht (siehe Figuren 6 bis 10, 12 bis 15) eingesetzt, deren Fläche in der Draufsicht etwas größer ist als die Fläche des Formstücks 6 in der Draufsicht. Eine Dicke der Substratschicht ist fast so groß wie die summierte Dicke der Anschlüsse 3 und des Modulkörpers 2, das heißt eine Gesamtdicke des Chipmoduls. Das Formstück 6 ist aus einem Einbettungsmaterial gebildet, das hinreichend temperaturbeständig bei Laminiertemperatur (beispielsweise bis 200°C) über eine Laminierdauer ist. Beispielsweise wird als Einbettungsmaterial temperaturbeständiges, thermoplastisches Polyurethan gewählt. Das Formstück 6 dient als Puffermaterial und verringert mechanische Spannungen in der Substratschicht und den Deckschichten durch Abbau von Spannungsspitzen. Das weiche, elastische und temperaturbeständige Einbettungsmaterial des Formstücks 6 verteilt durch das Schrumpfen beim Laminieren entstehende Druckspannungen weitgehend gleichmäßig im Durchbruch und verhindert seitlichen Druck auf die Anschlüsse 3 des Chipmoduls 1, die anderenfalls das Chipmodul 1 aus der Ebene drücken könnten. Das Einbettungsmaterial weist einen thermischen Ausdehnungskoeffizienten auf, der mindestens so groß wie ein thermischer Ausdehnungskoeffizient des Materials, zumindest der Substratschicht und vorzugsweise auch einer Deckschicht, ist (siehe Figuren 6 bis 11, 13 bis 15).

Figur 4 zeigt ein durch einen Schneidvorgang hergestelltes Formstück 6 nach dem Eindrücken des Modulkörpers 2 in den Formstückdurchbruch 7. Eine Fläche des Formstückdurchbruchs 7 in der Draufsicht ist kleiner als eine Fläche des Modulkörpers 2. Zum Eindrücken wird das Chipmodul 1 erwärmt (beispielsweise auf 150°C), so dass der Modulkörper 2 mit relativ geringen Druckkräften in den im Beispiel 4,7 mm x 4,7 mm großen Formstückdurchbruch 7 eingedrückt werden kann und danach fest mit dem Formstück 6 verbunden ist. Figur 5 zeigt das Formstück 6 aus Figur 4 in der Draufsicht.

In Figur 6 wurde unter einer Substratschicht 8 mit einem Durchbruch 9 zur Aufnahme des Formstückes 6 eine Deckschicht 10 angeordnet. Beispielsweise weist der Durchbruch 9 eine Größe von 14,5 mm x 9,5 mm auf und ist damit größer als die Außenmaße des Formstückes 6. Die Dicke der Substratschicht 8 beträgt beispielsweise 0,30 mm, die Dicke der Deckschicht 10 beispielsweise 0,03 mm. Deckschicht 10 und Substratschicht 8 können thermisch aneinander geheftet sein. Die Substratschicht 8 und die Deckschicht 10 können aus Polycarbonat gebildet sein. In den Durchbruch 9 wird das mit dem Chipmodul 1 vormontierte Formstück 6 platziert und an den Heftpunkten 11 an die Deckschicht 10 thermisch angeheftet. Auf einer Oberseite der Substratschicht 8 wird danach durch Verlegen eines Leiterbandes 12 ein Schaltungsmuster in Form einer Antennenspule erzeugt, wobei die Querungsbereiche mit den Kontaktierungsstellen des Leiterbandes 12 direkt über das Formstück 6 mit dem eingesetzten Chipmodul 1 bzw. die Anschlüsse 3 des Chipmoduls 1 gezogen werden. Beispielsweise weist das Leiterband 12 eine Breite von 0,3 mm und eine Dicke von 0,03 mm auf. Vorzugsweise ist das Leiterband 12 aus Kupfer gebildet und mit einer Isolation 15 aus einem Kernlack und einem Backlack versehen. Nach dem Verlegen des Leiterbandes 12 werden dessen Kontaktierungsstellen an den Schweißpunkten 13 mit den Anschlüssen 3 des Chipmoduls 1 mittels Schweißkontaktierung durch impulsförmige Theirnokompression kontaktiert.

Figur 7 zeigt eine Querschnittsansicht durch ein funktionelles Laminat 14 in Form eines Vorlaminats. Dabei ist auf die in Figur 6 gezeigte Anordnung eine weitere Deckschicht 10 auf der anderen Seite der Substratschicht 8 angeheftet und thermisch vorlaminiert. Dies erfolgt beispielsweise bei einer Temperatur von 190°C über einen Zeitraum von 30 Minuten. Anschließend wird das funktionelle Laminat 14 unter Druck abgekühlt. Das Chipmodul 1 ist in der Ebene der Substratschicht 8 in das Formstück 6 aus thermoplastischem Polyurethan eingebettet. Das Formstück 6, das zunächst dicker war als die Substratschicht 8, wird dabei in den Durchbruch 9 der Substratschicht 8 thermisch hinein planiert, wobei sich durch Schrumpf- und Fließprozesse die Größe des Durchbruches 9 etwas verkleinert. Die Ober- und Unterseite des Chipmoduls 1 sind nicht oder nur geringfügig vom Einbettungsmaterial eingeschlossen.

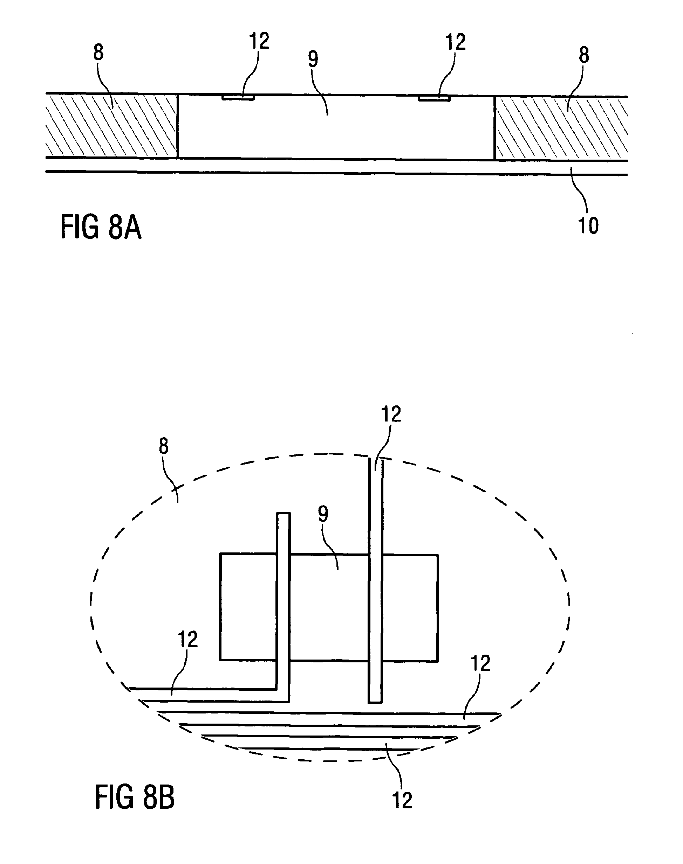

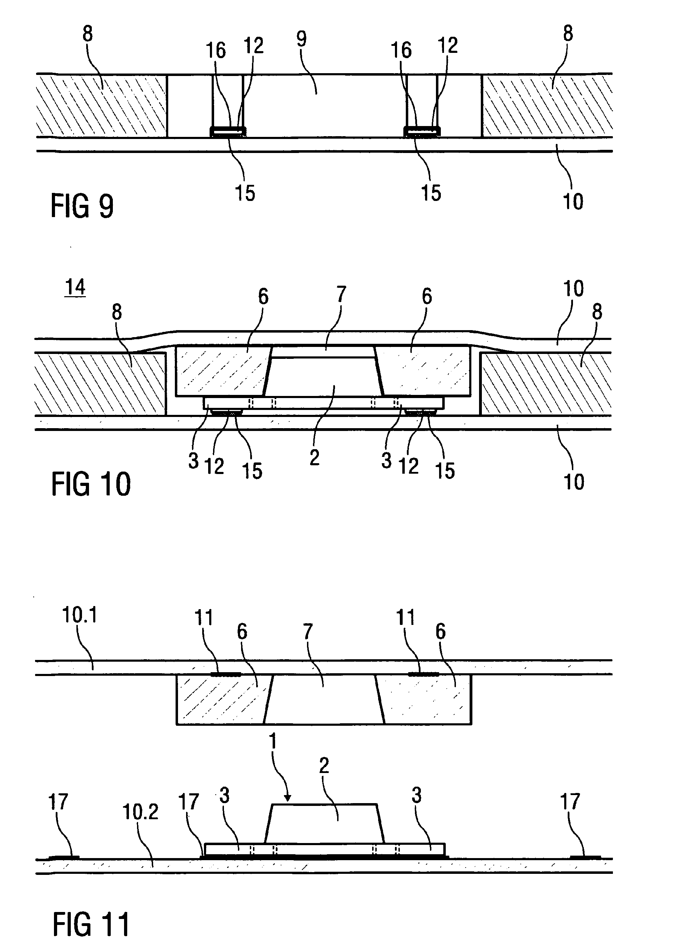

Figur 8 zeigt eine Substratschicht 8 mit untergehefteter Deckschicht 10 nach dem Verlegen des Leiterbandes 12 auf der Oberseite der Substratschicht 8 über den Durchbruch 9 hinweg. Ein Chipmodul 1 ist zu diesem Zeitpunkt noch nicht in den Durchbruch 9 eingesetzt. In einem weiteren Schritt werden mittels eines vorzugsweise kalten Stempels ungefähr in Größe des Formstückes 6 die Querungsbereiche des Leiterbandes 12 auf die untere Deckschicht 10 gedrückt, wie in Figur 9 gezeigt ist. Alternativ kann das Niederdrücken der Querungsbereiche des Leiterbandes 12 erfolgen, bevor die Deckschicht untergeheftet wird. Ebenso kann statt des Leiterbandes 12 mit rechteckigem Querschnitt ein Leiterdraht 12 mit rundem Querschnitt verwendet werden, der beim Niederdrücken gegen einen Amboss im Bereich des Durchbruchs 9 zu einem Leiterband 12 planiert wird, bevor die Deckschicht 10 untergeheftet wird. Anschließend wird mittels eines C0₂-Lasers die Kontaktstelle zwischen dem Leiterband 12 und dem Anschluss 3 abisoliert und eine Lotpaste 16 mit einem Schmelzpunkt unterhalb der für das Vorlaminieren verwendeten Temperatur auf den abisolierten Leiterbandabschnitten aufgebracht. Beispielsweise kann no-clean-Lotpaste mit einem Schmelzpunkt unterhalb der Volaminiertemperatur (Beispiel: Zinn-Wismut-Legierung mit Schmelzpunkt 139 °C) verwendet werden. Anschließend wird das Chipmodul 1 eingesetzt. Die Kontaktierung erfolgt dann beim Vorlaminieren.

Die beschriebene Lötkontaktierung kann sowohl für in den Durchbruch 9 eingedrückte Leiterbahnkontaktierungsstellen als auch für die in den Figuren 6 und 7 gezeigten und weitere Ausführungsformen verwendet werden. Beispielsweise wird der Leiterdraht 12 über den Durchbruch 9 geführt und planiert, die obere Deckschicht 10 aufgeheftet, die Kontaktierbereiche durch den Durchbruch 9 hindurch abisoliert und mit Lotpaste 16 beschichtet. Sinngemäß kann mit Leiterband 12 statt Leiterdraht 12 verfahren werden, wobei das Planieren des Leiterdrahtes 12 entfällt.

Figur 10 zeigt die Situation nach dem Einsetzen des vormontierten Formstückes 6 mit den Anschlüssen 3 des Chipmoduls 1 nach unten in den Durchbruch 9 und nach Auflegen der oberen Deckschicht 10. Nach dem anschließenden Vorlaminieren ergibt sich im Querschnitt durch das funktionelle Laminat 14 die gleiche Situation wie in Figur 7, jedoch liegt das aus den Leiterbahnen 12 gebildete Schaltungsmuster auf der den Anschlüssen 3 abgewandten Seite der Substratschicht 8. Anschließend können auf einem Montageautomaten weitere Bestückungsvorgänge von der Seite des funktionellen Laminats 14 erfolgen, auf dem das Schaltungsmuster mit Leiterdraht 12 oder Leiterbahnen 12 verlegt ist.

In den Figuren 11 bis 15 ist eine weitere Ausführungsform eines funktionellen Laminats 14 in Gestalt eines Vorlaminats gezeigt. Vorlaminate werden meist in größeren Nutzen hergestellt. Als Nutzen wird dabei eine Art Bogen bezeichnet, auf dem im Verband meist bis 64 Vorlaminate in Spalten und Reihen angeordnet sind. Aus Herstellungsgründen sind zwischen den Flächen der Vorlaminate gewöhnlich Zwischenräume (Stege) vorgesehen. In den Figuren 11 bis 15 ist jeweils nur ein Teil eines Nutzens abgebildet. Die Montage des Vorlaminats wird auf beide Deckschichten 10 und die Substratschicht 8 verteilt.

Auf die in Figur 11 gezeigte Deckschicht 10.1 werden entsprechend der Geometrie des Nutzens Formstücke 6 thermisch angeheftet. Im gezeigten Beispiel weisen die Formstückdurchbrüche 7 eine Fläche von 5,5 mm x 5,5 mm auf. Das Formstück 6 ist 0,4 mm dick. Auf die Deckfolie 10.2 sind Haftkleberflächen 17 der Größen 13 mm x 8 mm gedruckt, auf die die Chipmodule 1 mit ihren Anschlüssen 3 aufgesetzt werden. Als Haftkleber kann beispielsweise Haftkleber der Fa. Kissel & Wolf, Typ 1500/2, in einer Dicke von 15 µm aufgetragen werden.

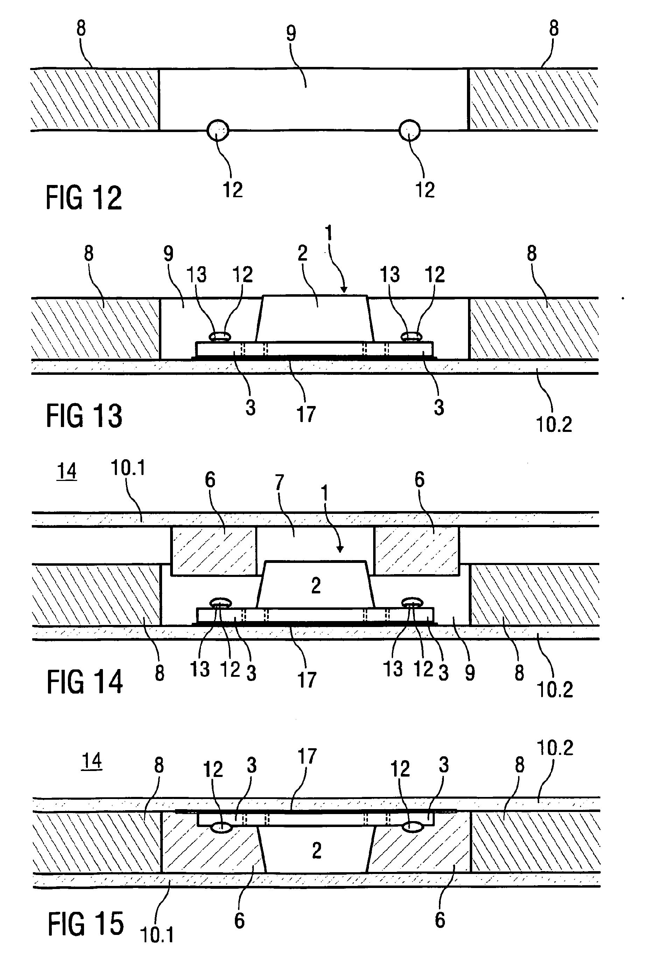

In Figur 12 ist eine Querschnittsansicht eines Ausschnitts der Substratschicht 8 gezeigt, wobei das Schaltungsmuster durch Verlegen von lackisoliertem (Kernlack und Backlack) Leiterdraht 12 des Durchmessers 112 µm erfolgt.

In Figur 13 werden die Substratschicht 8 und die Deckschicht 10.2 mit den aufgehefteten Chipmodulen 1 nun so zusammengeheftet, dass die Anschlüsse 3 die den Durchbruch 9 querenden Kontaktierungsstellen des Leiterdrahtes 12 in das Innere des Durchbruches 9 drücken. Von der offenen Seite des Durchbruchs 9 her erfolgt die Kontaktierung der Kontaktierungsstellen des Leiterdrahtes 12 mit den Anschlüssen 3 mittels impulsartiger Thermokompression. Dabei wird der Querschnitt des Leiterdrahtes 12 etwas deformiert. Anstatt des Leiterdrahtes 12 kann auch Leiterband 12 verwendet werden.

In Figur 14 wird die Deckschicht 10.1 mit den angehefteten Formstücken 6 so auf die obere Seite der Substratschicht 8 gelegt und angeheftet, dass die Modulkörper 2 in die Formstückdurchbrüche 7 hineinragen. Anschließend erfolgt die Vorlamination, so dass sich die in Figur 15 gezeigte Situation ergibt.

Ein Anheften der Formstücke 6 an die Deckschicht 10, 10.1, 10.2 ist alternativ mittels Kleber möglich.

Die angegebenen Abmessungen und Dimensionen sind Beispielwerte und können in allen Ausführungsformen abweichend gewählt werden. Statt des Chipmoduls 1 kann eine anders geartete funktionelle Komponente vorgesehen sein, beispielsweise ein nicht gekapselter ("nackter") Chip.

Die über den Durchbruch 9 geführte Leiterbahn oder der Leiterdraht 12 wird grundsätzlich auf beiden Seiten des Durchbruchs 9 an der Substratschicht 8 befestigt.

**BEZUGSZEICHENLISTE**

| | |
|---|---|
| 1 | Chipmodul, funktionelle Komponente |
| 2 | Modulkörper |
| 3 | Anschluss |
| 4 | Integrierter elektronischer Schaltkreis |
| 5 | Kontaktierdraht |
| 6 | Formstück |
| 7 | Formstückdurchbruch |
| 8 | Substratschicht |
| 9 | Durchbruch |
| 10, 10.1, 10.2 | Deckschicht |
| 11 | Heftpunkt |
| 12 | Leiterband, Leiterdraht |
| 13 | Schweißpunkt |
| 14 | Funktionelles Laminat |
| 15 | Isolation |
| 16 | Lotpaste |
| 17 | Haftkleberfläche |

## Patentansprüche

1. Verfahren zur Herstellung eines funktionellen Laminats (14), wobei das Verfahren die Schritte umfasst:
- Bereitstellen mindestens einer thermoplastischen Kunststofffolie als Substratschicht (8),
- Erzeugen mindestens eines Durchbruchs (9) in der Substratschicht (8),
- Einbringen mindestens einer funktionellen Komponente (1) in den Durchbruch (9),
- Laminieren der Substratschicht (8) mit mindestens einer weiteren Kunststofffolie als Deckschicht (10, 10.1, 10.2) unter Druck und Zuführung von Wärme,
wobei ein weiches, elastisches und temperaturbeständiges Einbettungsmaterial so angeordnet wird, dass die funktionelle Komponente (1) zumindest in der Substratschicht (8) vom Einbettungsmaterial umgeben ist, das einen Wärmeausdehnungskoeffizienten und einen Schrumpfwert aufweist, die jeweils mindestens so groß wie ein Wärmeausdehnungskoeffizient und ein Schrumpfwert des Materials der Substratschicht (8) sind, wobei das Einbettungsmaterial und das Material der Substratschicht ein ähnliches oder gleiches Schrumpfverhalten bei Erwärmung aufweisen,
**dadurch gekennzeichnet, dass**
das Einbettungsmaterial als ein Formstück (6) mit einem Formstückdurchbruch (7) gebildet wird, wobei die funktionelle Komponente (1) zumindest teilweise in den Formstückdurchbruch (7) eingebracht wird, wobei das Formstück (6) vor oder nach dem Einbringen der funktionellen Komponente (1) in den Durchbruch (9) der Substratschicht (8) eingebracht wird.

2. Verfahren nach Anspruch 1, **dadurch gekennzeichnet, dass** eine Fläche des Formstücks (6) mit der eingesetzten funktionellen Komponente (1) in der Draufsicht kleiner ist als eine Fläche des Durchbruchs (9), wobei eine Dicke des Formstücks (6) größer oder gleich einer Dicke der Substratschicht (8) ist.

3. Verfahren nach Anspruch 1 oder 2, **dadurch gekennzeichnet, dass** die funktionelle Komponente (1) in das Formstück (6) eingedrückt oder eingegossen wird.

4. Verfahren nach einem der Ansprüche 1 bis 3, **dadurch gekennzeichnet, dass** die entisolierten Kontaktierungsstellen des Leiterbandes (12) oder Leiterdrahtes (12) mit den Anschlüssen (3) vor oder nach der Montage der funktionellen Komponente (1) mit dem Formstück (6) kontaktiert werden.

5. Verfahren nach einem der Ansprüche 1 bis 4, **dadurch gekennzeichnet, dass** das Formstück (6) durch Gießen oder durch heißes Prägen oder durch einen Schneidvorgang oder durch Eingießen der funktionellen Komponente (1) hergestellt wird.

6. Verfahren nach einem der Ansprüche 1 bis 5, **dadurch gekennzeichnet, dass** der Formstückdurchbruch (7) kleiner ist als der darin einzubringende Teil der funktionellen Komponente (1), wobei die funktionelle Komponente (1) in den Formstückdurchbruch (7) eingedrückt wird.

7. Verfahren nach einem der Ansprüche 1 bis 6, **dadurch gekennzeichnet, dass** das Formstück (6) mit der funktionellen Komponente (1) in den Durchbruch eingesetzt und an der Deckschicht (10, 10.1, 10.2) angeheftet wird.

8. Verfahren nach einem der Ansprüche 1 bis 7, **dadurch gekennzeichnet, dass** das Formstück (6) auf einer der Deckschichten (10.1, 10.2) angeheftet wird, wobei die funktionelle Komponente (1) auf einer anderen der Deckschichten (10.2, 10.1) angeheftet wird, wobei das Schaltungsmuster auf der Substratschicht (8) mit über den Durchbruch (9) geführten Querungsbereichen der Leiterbahn (12) oder des Leiterdrahtes (12) verlegt wird, wobei die Substratschicht (8) und die Deckschicht (10.2, 10.1) mit der funktionellen Komponente (1) so zusammen geheftet werden, dass die Anschlüsse (3) der funktionellen Komponente (1) die Querungsbereiche der Leiterbahn (12) oder des Leiterdrahtes (12) in den Durchbruch (9) biegen, so dass die Kontaktierungsstellen unter den Anschlüssen (3) liegen, woraufhin die Kontaktierung durchgeführt wird, wobei die Deckschicht (10.1, 10.2) mit dem Formstück (6) an die Substratschicht (8) angeheftet und anschließend laminiert wird.

9. Funktionelles Laminat (14), umfassend:
- mindestens eine thermoplastische Kunststofffolie als Substratschicht (8),
- mindestens einen Durchbruch (9) in der Substratschicht (8),
- mindestens eine im Durchbruch angeordnete funktionelle Komponente (1),
- mindestens eine an die Substratschicht (8) unter Druck und Wärmezufuhr anlaminierte weitere Kunststofffolie als Deckschicht (10, 10.1, 10.2),
wobei ein weiches, elastisches und temperaturbeständiges Einbettungsmaterial so angeordnet ist, dass die funktionelle Komponente (1) zumindest nahezu ausschließlich in der Substratschicht (8) vom Einbettungsmaterial umgeben ist, das einen Wärmeausdehnungskoeffizienten und einen Schrumpfwert aufweist, die jeweils mindestens so groß wie ein Wärmeausdehnungskoeffizient und ein Schrumpfwert des Materials der Substratschicht (8) sind, wobei das Einbettungsmaterial und das Material der Substratschicht ein ähnliches oder gleiches Schrumpfverhalten bei Erwärmung aufweisen,
**dadurch gekennzeichnet, dass**
das Einbettungsmaterial als ein Formstück (6) mit einem Formstückdurchbruch (7) ausgebildet ist, wobei die funktionelle Komponente (1) zumindest teilweise in den Formstückdurchbruch (7) eingebracht ist.

10. Funktionelles Laminat (14) nach Anspruch 9, hergestellt mittels eines Verfahrens nach einem der Ansprüche 1 bis 8.

## Claims

1. A method for producing a functional laminate (14), wherein the method comprises the following steps:
- providing at least one thermoplastic film as the substrate layer (8),
- producing at least one aperture (9) in the substrate layer (8),
- inserting at least one functional component (1) into the aperture (9),
- laminating the substrate layer (8) with at least one additional plastic film as the cover layer (10, 10.1, 10.2) by applying pressure and supplying heat,
wherein a soft, elastic and temperature-resistant embedding material is disposed such that the functional component (1) is surrounded by the embedding material at least in the substrate layer (8), said embedding material having a thermal expansion coefficient and a shrinkage value which are each at least as large as a thermal expansion coefficient and a shrinkage value of the material of the substrate layer (8), wherein the embedding material and the material of the substrate layer have a similar or the same shrinkage behaviour when heated,
**characterised in that**
the embedding material is formed as a moulded part (6) having a moulded part aperture (7), wherein the functional component (1) is at least partially inserted into the moulded part aperture (7), wherein the moulded part (6) is inserted into the aperture (9) of the substrate layer (8) prior to or after insertion of the functional component (1).

2. The method according to Claim 1,
**characterised in that**
a surface of the moulded part (6) having the inserted functional component (1) in the top view is smaller than a surface of the aperture (9), wherein a thickness of the moulded part (6) is larger than or equal to a thickness of the substrate layer (8).

3. The method according to Claim 1 or 2,
**characterised in that**
the functional component (1) is either pressed or moulded into the moulded part (6).

4. The method according to any of Claims 1 to 3,
**characterised in that**
the contact points of the conductor strip (12) or the conductor wire (12), from which the insulation has been stripped, are contacted with the terminals (3) prior to or after assembly of the functional component (1) having the moulded part (6).

5. The method according to any of Claims 1 to 4,
**characterised in that**
the moulded part (6) is produced by casting or hot-stamping or by means of a cutting process or by embedding of the functional component (1).

6. The method according to any of Claims 1 to 5,
**characterised in that**
the moulded part aperture (7) is smaller than the part of the functional component (1) to be inserted therein, wherein the functional component (1) is pressed into the moulded part aperture (7).

7. The method according to any of Claims 1 to 6,
**characterised in that**
the moulded part (6) having the functional component (1 is inserted into the aperture and is affixed to the cover layer (10, 10.1, 10.2).

8. The method according to any of Claims 1 to 7,
**characterised in that**
the moulded part (6) is affixed to one of the cover layers (10.1, 10.2), wherein the functional component (1) is affixed to another one of the cover layers (10.2, 10.1), wherein the circuit pattern on the substrate layer (8) is laid with crossing areas of the conductor strip (12) or the conductor wire (12) being guided across the aperture (9), wherein the substrate layer (8) and the cover layer (10.2, 10.1) are affixed to the functional component (1) such that the terminals (3) of the functional component (1) bend the crossing areas of the conductor strip (12) or the conductor wire (12) into the aperture (9), such that the contact points lie below the terminals (3), whereupon the contacting is performed, wherein the cover layer (10.1, 10.2) having the moulded part (6) is affixed to the substrate layer (8) and is subsequently laminated.

9. A functional laminate (14), comprising:
- at least one thermoplastic film as the substrate layer (8),
- at least one aperture (9) in the substrate layer (8),
- at least one functional component (1) disposed in the aperture,
- at least one additional plastic film as the cover layer (10, 10.1, 10.2) being laminated to the substrate layer (8) by applying pressure and supplying heat,
wherein a soft, elastic and temperature-resistant embedding material is disposed such that the functional component (1) is surrounded by the embedding material at least almost exclusively in the substrate layer (8), said embedding material having a thermal expansion coefficient and a shrinkage value which are each at least as large as a thermal expansion coefficient and a shrinkage value of the material of the substrate layer (8), wherein the embedding material and the material of the substrate layer have a similar or the same shrinkage behaviour when heated,
**characterised in that**
the embedding material is formed as a moulded part (6) having a moulded part aperture (7), wherein the functional component (1) is at least partially inserted into the moulded part aperture (7).

10. The functional laminate (14) according to Claim 9, produced by means of a method according to any of Claims 1 to 8.

## Revendications

1. Procédé de fabrication d'un stratifié fonctionnel (14), le procédé comportant les étapes suivantes :
- fournir au moins un film thermoplastique comme couche de substrat (8),
- produire au moins une ouverture (9) dans la couche de substrat (8),
- insérer au moins un composant fonctionnel (1) dans l'ouverture (9),
- stratifier la couche de substrat (8) avec au moins un autre film plastique comme couche de recouvrement (10, 10.1, 10.2) sous pression et avec apport de chaleur,
un matériau d'enrobage souple, élastique et à résistance thermique étant disposé de telle manière que le composant fonctionnel (1), au moins dans la couche de substrat (8), est entouré par le matériau d'enrobage ayant un coefficient de dilatation thermique et une valeur de retrait, dont chacun est au moins aussi grand qu'un coefficient de dilatation thermique et qu'une valeur de retrait du matériau de la couche de substrat (8), le matériau d'enrobage et le matériau de la couche de substrat présentant un comportement de retrait similaire ou égal sous l'effet de la chaleur,
**caractérisé en ce que**
le matériau d'enrobage est réalisé sous la forme d'une pièce moulée (6) avec une ouverture de pièce moulée (7), le composant fonctionnel (1) étant au moins partiellement inséré dans l'ouverture de pièce moulée (7), la pièce moulée (6) étant insérée dans l'ouverture (9) de la couche de substrat (8) avant ou après l'insertion du composant fonctionnel (1).

2. Procédé selon la revendication 1, **caractérisé en ce qu'**une surface de la pièce moulée (6) avec le composant fonctionnel (1) introduit dedans est, vue de dessus, inférieure à une surface de l'ouverture (9), une épaisseur de la pièce moulée (6) étant supérieure ou égale à une épaisseur de la couche de substrat (8).

3. Procédé selon la revendication 1 ou 2, **caractérisé en ce que** le composant fonctionnel (1) est enfoncé ou moulé dans la pièce moulée (6).

4. Procédé selon l'une quelconque des revendications 1 à 3, **caractérisé en ce que** les parties de contact désisolées de la bande conductrice (12) ou du fil conducteur (12) sont mises en contact avec les bornes (3) avant ou après l'assemblage du composant fonctionnel (1) avec la pièce moulée (6).

5. Procédé selon l'une quelconque des revendications 1 à 4, **caractérisé en ce que** la pièce moulée (6) est fabriquée par moulage ou par estampage à chaud ou par un procédé de coupe ou en moulant le composant fonctionnel (1).

6. Procédé selon l'une quelconque des revendications 1 à 5, **caractérisé en ce que** l'ouverture de pièce moulée (7) est inférieure à la partie du composant fonctionnel (1) destinée à être insérée dans celle-ci, le composant fonctionnel (1) étant enfoncé dans l'ouverture de pièce moulée (7).

7. Procédé selon l'une quelconque des revendications 1 à 6, **caractérise en ce que** la pièce moulée (6) avec le composant fonctionnel (1) est introduite dans l'ouverture et est attachée à la couche de recouvrement (10, 10.1, 10.2).

8. Procédé selon l'une quelconque des revendications 1 à 7, **caractérisé en ce que** la pièce moulée (6) est attachée sur une des couches de recouvrement (10.1, 10.2), le composant fonctionnel (1) étant attaché sur une autre des couches de recouvrement (10.2, 10.1), la structure de circuit étant posée sur la couche de substrat (8) avec des zones d'intersection de la bande conductrice (12) ou du fil conducteur (12) qui sont conduites à travers de l'ouverture (9), la couche de substrat (8) et la couche de recouvrement (10.2, 10.1) étant attachées au composant fonctionnel (1) de telle manière que les bornes (3) du composant fonctionnel (1) fléchissent les zones d'intersection de la bande conductrice (12) ou du fil conducteur (12) dans l'ouverture (9), de façon que les parties de contact se situent au-dessous des bornes (3), après quoi le procédé de mise en contact est effectué, la couche de recouvrement (10.1, 10.2) avec la pièce moulée (6) étant attachée à la couche de substrat (8) et étant ensuite stratifiée.

9. Stratifié fonctionnel (14), comportant :
- au moins un film thermoplastique comme couche de substrat (8),
- au moins une ouverture (9) dans la couche de substrat (8),
- au moins un composant fonctionnel (1) qui est disposé dans l'ouverture (9),
- au moins un autre film plastique comme couche de recouvrement (10, 10.1, 10.2) qui est stratifié à la couche de substrat (8) sous pression et avec apport de chaleur,
un matériau d'enrobage souple, élastique et à résistance thermique étant disposé de telle manière que le composant fonctionnel (1), au moins à peu près exclusivement, dans la couche de substrat (8), est entouré par le matériau d'enrobage ayant un coefficient de dilatation thermique et une valeur de retrait, dont chacun est au moins aussi grand qu'un coefficient de dilatation thermique et qu'une valeur de retrait du matériau de la couche de substrat (8), le matériau d'enrobage et le matériau de la couche de substrat présentant un comportement de retrait similaire ou égal sous l'effet de la chaleur,
**caractérisé en ce que**
le matériau d'enrobage est réalisé sous la forme d'une pièce moulée (6) avec une ouverture de pièce moulée (7), le composant fonctionnel (1) étant au moins partiellement inséré dans l'ouverture de pièce moulée (7).

10. Stratifié fonctionnel (14) selon la revendication 9, fabriqué par un procédé selon l'une quelconque des revendications 1 à 8.
